# EUROPEAN PATENT APPLICATION

(11) **EP 4 787 298 A1**
(43) Date of publication of application: **05.08.2026**
(21) Application number: 25193939.3
(22) Date of filing: 05.08.2025
(51) Int. Cl.: G06T 7/00, G06T 7/521, B65G 1/10, E04F 15/024, G06F 30/13

(54) **FLOOR HEIGHT COMPENSATION**

(30) Priority: 30.01.2025 US 202563751487 P
(71) Applicant: AutoStore Technology AS, 5578 Nedre Vats (NO)
(72) Inventor: VIKSE, Mats Hovland, 5578 Nedre Vats (NO); JOSHI, Parth, 5578 Nedre Vats (NO); FJELDHEIM, Ivar, 5578 Nedre Vats (NO)
(74) Representative: Kilburn & Strode LLP

(57) **Abstract**

The disclosure relates to a computer-implemented method for compensating for height deviations in a floor. The method comprises obtaining a 3D model of the floor, analysing the 3D model to identify one or more points of height deviation in the floor, and producing a specification which specifies the location and magnitude of each identified point of deviation.

## Description

### TECHNICAL 'FIELD

The disclosure relates to floor height compensation. More particularly, it relates to a method for compensating for height deviations in a floor for installation of an automated storage and retrieval system.

### BACKGROUND

Traditional storage solutions usually involve the arrangement of goods on rows of shelves within a warehouse. The shelf location for each item is recorded in an inventory, and goods are retrieved from the shelves by a stock picker. The shelves are restocked and the inventory updated, as needed, as goods enter and leave the warehouse.

Warehouse workers may be assisted by robotic pickers and by automated inventory management systems. Automated transit systems may also be implemented in traditional warehouse set-ups to move goods from their inventory location to a picking and/or packing station.

An alternative to a traditional warehouse set-up is an automated storage and retrieval system in which robots retrieve items from their logged location within the warehouse and deliver the items to a packing station or port. Such systems can reduce or eliminate the space needed to pass between rows of shelves to access stock, thereby removing the need for broad aisles within the warehouse. One example of such a system involves placing goods in bins or containers that are configured to be stacked, side by side, within a three-dimensional grid. A rail system is arranged on top of the grid, along which robotic container-handling vehicles configured to lift containers from the grid can travel. The container-handling vehicles are configured to transport containers from the grid and to deliver them to ports or stations at the periphery of the grid so that the goods within the container can be picked and packed.

To ensure optimal performance of such an automated storage and retrieval system, it is important that the grid is supported on a substantially flat surface. Without a flat surface upon which the grid rests/is supported, any deviations in the floor height may translate to the storage grid and in particular the rail system atop the storage grid, upon which the robotic container-handling vehicles travel. Height deviations translated from the floor to the rail system may hinder the operation of those robots on the grid, particularly in the event of step-changes in the height of the rails. With regards to the storage columns of the grid itself, height deviations in the floor may lead to mismatches in the heights of storage positions within the columns, resulting in problems depositing and retrieving storage containers.

Typically, automated storage and retrieval system grids are installed in existing warehouses and are supported directly on the warehouse floor. Traditionally, any height deviations in the warehouse floor have been addressed by repouring the existing concrete floor or designing an entirely new floor that meets the requisite flatness criteria. These approaches are time-consuming and costly, increasing the overall installation time and cost for a storage grid.

One or more aspects of the invention of the present application are set out in the claims.

### BRIEF DESCRIPTION OF THE DRAWINGS

The disclosure will now be described in more detail in connection with a number of exemplary embodiments shown in the accompanying drawings, in which:
Fig. 1 shows a perspective view of a storage system comprising a grid and a plurality of robotic container-handling vehicles configured to retrieve and/or rearrange goods stored within the grid;
Fig. 2 shows a top view of the system of Fig. 1;
Fig. 3A shows a side view of a first robotic container-handling vehicle suitable for use in the system of Fig. 1;
Fig. 3B shows a side view of a second robotic container-handling vehicle suitable for use in the system of Fig. 1;
Fig. 3C is a perspective side view of the robot of Fig. 3B;
Fig. 4 shows a computing device for implementing the operations described herein;
Fig. 5A shows a 3D model of a floor designated for installation of a storage grid;
Fig. 5B shows an inverted 3D model corresponding to the model of Fig. 5A;
Fig. 6A shows a grid overlay on a 3D model of a floor;
Fig. 6B shows an alternative grid overlay on a 3D model of a floor; and
Fig. 7 shows a method according to the present disclosure.
Figs. 8A-D are an exploded view of height-adjustable foot devices, with the height-adjustable foot device comprising a (lower) adjustable foot and an (upper) adjustable wedge device, and in particular:

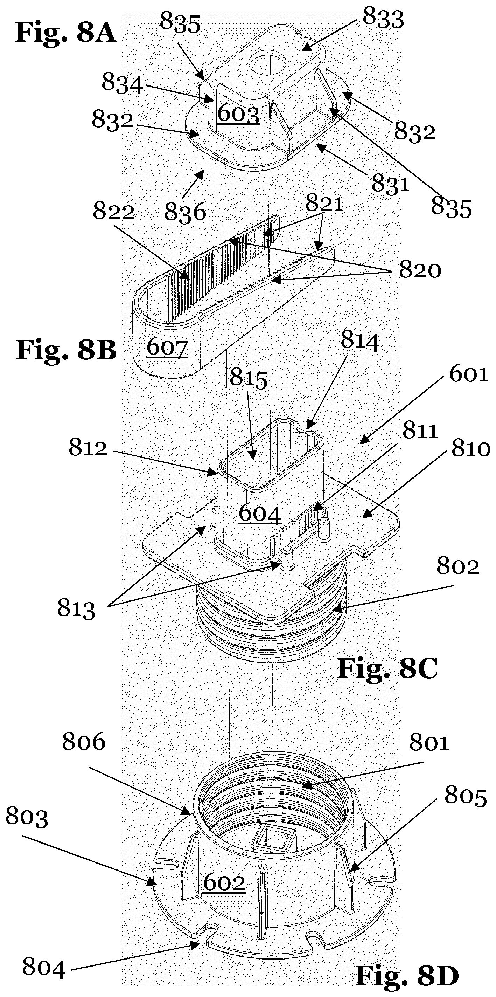

   Fig. 8A shows the wedge device upper part;

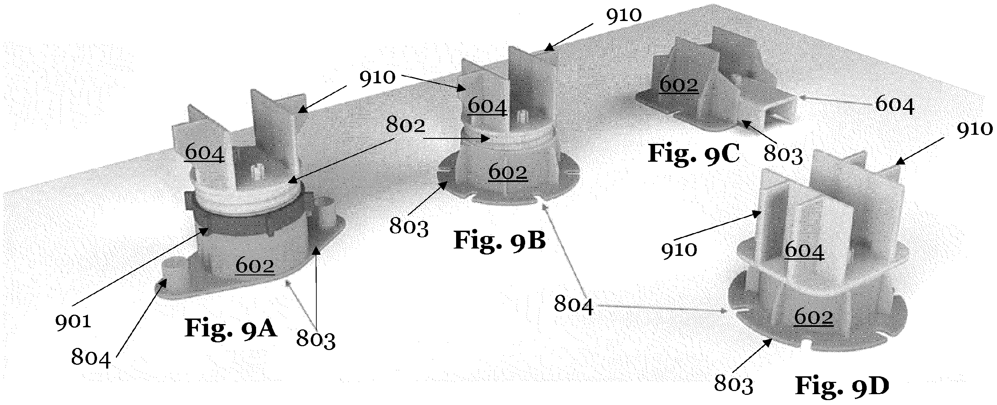

   Fig. 9B shows the wedge device lower part;
   Fig. 9C shows the adjustable foot male (or upper) component; and,
   Fig. 9D shows the adjustable foot female (or lower) component; and
   Figs. 9A-D show different implementations of (lower adjustable feet, as described herein.

### DETAILED DESCRIPTION

In overview, the disclosure relates to a method for compensating for height deviations in a floor for the purposes of installing a storage grid of an automated storage and retrieval system on that floor. Typically, any warehouse floor designated for installation of a storage grid will not be perfectly flat due to imperfections, tolerances, or other reasons. In other words, any given floor designated for installation might not represent a perfectly flat plane upon which the grid can be supported. As such, the floor will exhibit deviations in its height or flatness, which as described above, may lead to issues in the functioning of the automated storage and retrieval system. The present disclosure provides a means for identifying those deviations, particularly those deviations located at positions of contact between the storage grid and the floor, as well as a means for compensating for those deviations to ensure that the storage grid is supported on a substantially flat surface when it is installed. In addition, the present disclosure provides a user-friendly means for installing the storage grid whilst simultaneously compensating for the deviations in the floor. In addition, the present disclosure provides a means for visualising the locations at which the grid is supported on the floor.

A method according to the present disclosure involves obtaining a 3D model of the floor and analysing the 3D model to identify one or more points of height deviation in the floor, or in other words, identifying one or more points of deviation in the flatness of the floor. After identifying the points of height deviation, the method involves producing a specification which specifies the location and magnitude of each identified point of deviation.

In general, deviation in height and deviation in flatness refer to the same concept throughout this description. The 3D model may be obtained using any suitable 3D scanning technique apparent to the skilled person, such as using a LiDAR or other type of laser scanner. The method may include obtaining the 3D model by carrying out the scanning of the floor. Alternatively, the 3D model may be obtained by retrieval from data storage, such as from a computer-readable memory, whereby scanning of the floor to produce the 3D model has already been carried out at an earlier time.

As described in more detail below, the points of height deviation may be determined from the 3D model of the floor by determining the height difference between the highest point of the floor and every other point of the floor. In other words, any given point of the floor that is not the highest point will be offset by some height difference relative to the highest point. For any given point, the offset in height between that point and the highest point corresponds to the amount of compensation required at that point in order to produce a flat floor that is set at the height of the highest point. In general, the present disclosure compensates for height deviations by identifying those points that are lower than a highest point of the floor and which will be in contact with the storage grid when installed, and provides various means to raise those points up to the same level as the highest point of the floor. In other words, height compensation is generally centred on providing a flat surface at the height of the highest point (or at least the highest point of the floor that will be in contact with the grid). In this way, the disclosed techniques are additive, specifically at the contact locations, avoiding the costly and time-consuming need to flatten a floor by reduction (e.g. by sanding or otherwise removing portions of the floor), or by wholesale repouring.

Moreover, disclosed examples involve identifying the points of the floor at which the storage grid will be in contact with the floor. As described in more detail below, a storage grid may be supported on the floor by means of numerous vertical frame members and/or by means of numerous horizontal floor rails. The nature of the structure of the grid means that not every point of a floor will be supporting the grid, and thus not every point of the floor (those points not supporting the grid) need to have height deviations compensated for. As such, in some examples, height compensation is only provided for the minimum set of points necessary, i.e., only those points in contact with the grid. In some examples, the disclosed methods comprise determining a set of contact points representing the locations of the floor where the storage grid will be supported, or in contact with, the floor, and determining a height difference between each contact point and the highest point of the floor. Optionally, the identified highest point of the floor may not be the absolute highest point of the floor, but may instead be the highest point in the set of contact points, since it is only those points that the grid contacts the floor that are relevant for height compensation.

In some examples, the height deviations for each contact point may be determined using an inverted 3D model of the floor. The inverted 3D model is obtained by inverting the original 3D model of the floor in a horizontal plane set at the height of the identified highest point (e.g., highest absolute point or highest contact point), such that the height coordinate of each point of the inverted 3D model corresponds to the height difference between the corresponding point in the original 3D model and the identified highest point in the original 3D model. The horizontal coordinates in the inverted 3D model remain unchanged.

In other words, the inverted 3D model is based on the original 3D model with its height coordinate reflected in a horizontal plane positioned at the height of the identified highest point. The model is then translated vertically such that the height coordinate of the point corresponding to the original highest point is zero. The height coordinate of every other point is thus equal to the value of the difference in height between the corresponding original point and the original highest point. In this way, the inverted 3D model may be used to directly provide the necessary height compensation for any given point of the floor.

In some embodiments, a model of the storage grid, or at least a model of the base of the storage grid (to indicate the points of contact between the grid and the floor) may be overlaid on the 3D model or inverted 3D model of the floor to determine the contact points and the height compensation required for each contact point. As mentioned above, a specification may be generated that specifies, for each contact point, an amount of height compensation required for that point in order for the storage grid to be supported upon a flat surface.

In some embodiments, the specification includes details of the means for providing that height compensation. For example, the specification may include one or more of: a bill of materials specifying a number of shims required to provide the height compensation for each contact point, an amount of height adjustment required for height adjustable elements of the storage grid corresponding to the set of contact points, and relative length information for each of a plurality of vertical frame members of the storage grid, wherein each vertical frame member corresponds to a contact point. In some examples, the height compensation is provided by adjustable feet arranged between horizontal floor rails and the floor, such as feet described in European application EP25154841.8 which is incorporated herein by reference. In such examples, the floor rails are suspended above the floor and the contact points between the grid and the floor are provided only by the adjustable feet. The specification in these examples may include, for each contact point (i.e., for each adjustable foot), a height or amount of height adjustment required such that the floor rails suspended by the feet lie substantially flat.

A storage grid may then be installed on the floor based on the specification, which is used to define and inform the necessary height compensation for every point that the grid is in contact with and supported by the floor. For example, installing the storage grid using the specification may involve placing the requisite number of shims at the relevant locations between the floor and the storage grid, and/or may involve adjusting various height adjustable elements of the grid according to the specification, and/or may involve installing vertical frame members of specific and varying lengths at various locations according to the specification.

### Automated storage and retrieval system overview

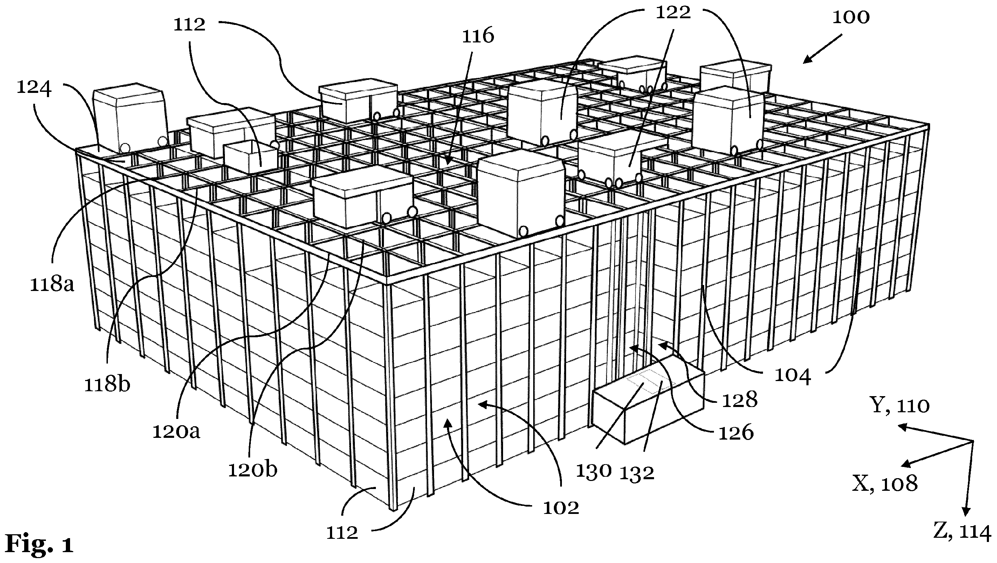

Referring to the embodiment shown in Fig. 1, a grid 100 comprises a frame formed by a plurality of generally rectilinear, adjacent vertical columns 102 formed between vertical frame members 104 and extending in the X and Y directions 108, 110. The grid elements may be fabricated of any appropriate material; for example, the frame members may be formed of extruded aluminium. Storage containers or bins 112 are stacked on top of each other, preferably in a self-supporting manner, in the Z direction 114 in the columns 102, forming a storage volume of storage cells for respective bins 112 extending in the X, Y and Z directions 108, 110, 114.

A rail system or network 116 is formed on top of the grid 100 and comprises pairs of vehicle rails or tracks 118a, 118b and 120a, 120b, respectively extending in the X and Y directions 108, 110. Robotic container-handling vehicles, or robots, 122, which can be of a range of size, shape and function are provided and configured to run on the rails 118, 120 and to transport bins 112 in both the X and Y directions 108, 110. The robots 122 are additionally configured to lift and lower bins 112 from/into the columns 102 in the Z direction 114, the bins 112 optionally being guided by the vertical frame members 104. The robots 122 access the bins 112 via access openings 124 above the columns 102 and formed between the rails 118, 120.

Some columns 102 may be used for alternative purposes than bin storage. For example, port columns 126, 128 comprise port or access columns allowing transfer of a bin 112 in and/or out of the grid 100. Port columns 126, 128 provide a vertical channel for lifting of a bin 112 from, or lowering of a bin 112 to, a port or ports 130, 132. The ports 130, 132 are shown in Fig. 1 at the lowest level of the grid, however ports can be located at any vertical position along the column. The respective port columns 126, 128 can be assigned for removing ('drop-off') and/or returning or delivering ('pick-up') bins 112 from/to the grid 100. The ports 130, 132 are therefore configured to allow bins 112 to be removed and reintroduced (horizontally) into the associated port column. As such, a port 130, 132 can comprise a conveyor (not shown in Fig. 1) onto which a bin 112 may be lowered and transported horizontally out of the port column. The port columns 126, 128 include an opening or access point through which bins 112 can enter and leave the column.

Bins 112 can be transported along the top of the grid 100 to and/or from a port column 126, 128 by robots 122, and from a port 130, 132 to a location outside the grid 100, which may be an access station (not shown) for processing of the bin 112 or its contents, such as a picking station for adding content to, or removing content from, the bin 112. In alternative examples (not shown), the bin 112 may be transported to a port of another grid on the same or another level, or to an external facility. Transport of bins 112 to and from ports 130, 132 may be by any appropriate means (not shown) including conveyors, transport vehicles, lifts or robots.

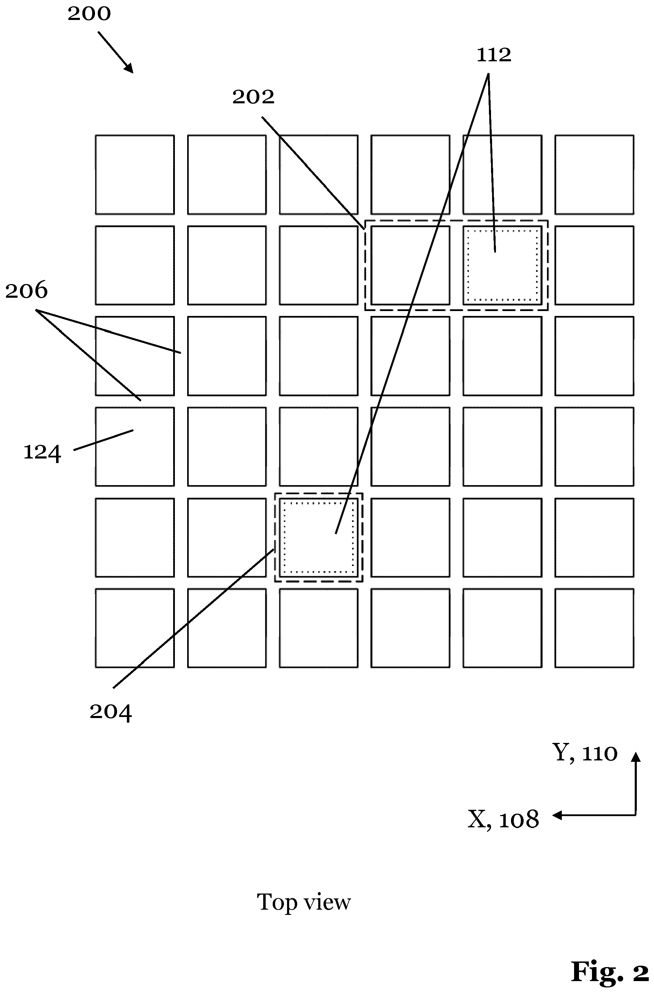

Referring to the embodiment shown in Fig. 2, the X-Y configuration 200 of the rail system 116 can be seen in more detail, together with robots 202, 204 of different types. The rail system includes rails 206 defining between them vertical column access openings 124 for access to bins 112. The rails 206 can be any appropriate type for permitting travel of the robots 202, 204 in the X and Y directions 108, 110 thereon, including (not shown) groove-type rails for receiving vehicle wheels, or protrusion-type rails for engaging wheel recesses. Each rail 206 may comprise a single track or multiple parallel tracks in each of the X and Y directions 108, 110.

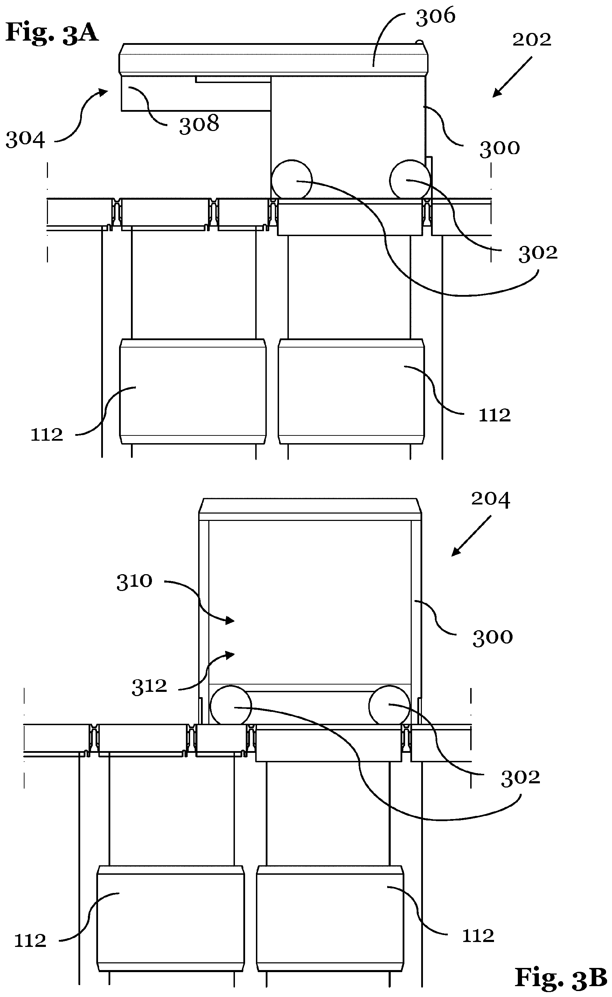

A first, 'cantilever' type of robot 202 is shown in more detail in Fig. 3A and includes a body 300, a set of wheels 302 and a lifting device 304. The body 300 contains operational equipment (not shown) for the robot 202 including drive, power and control systems. The wheels 302 permit movement of the robot 202 in one of the X and Y directions, an additional set of wheels (not visible in this view) permitting movement in the other of the X and Y directions, in both cases along the respective rails or tracks 206. One or both sets of wheels can be raised or lowered to permit selective engagement of the rails for movement in the desired direction. The lifting device 304 includes a cantilever element 306 extending in the X-Y plane from the top of the body 300, and a gripping device 308, which is raisable and lowerable from the cantilever element 306. The gripping device 308 is configured to grip or engage a bin 112; for example, by gripping a part of the bin 112, or by passively or actively engaging a suitably configured part of the bin 112.

A second, 'internal cavity' type of robot 204 is shown in more detail in Fig. 3B and includes, as an alternative to the cantilevered lifting system, an internal cavity 310 within the body 300 and in which the lifting device 312 including a gripping device (not shown) is located. In this case, the body 300 includes the robot's operational equipment and a storage space for one or more bins 112, for use, for example, while transporting the bin 112.

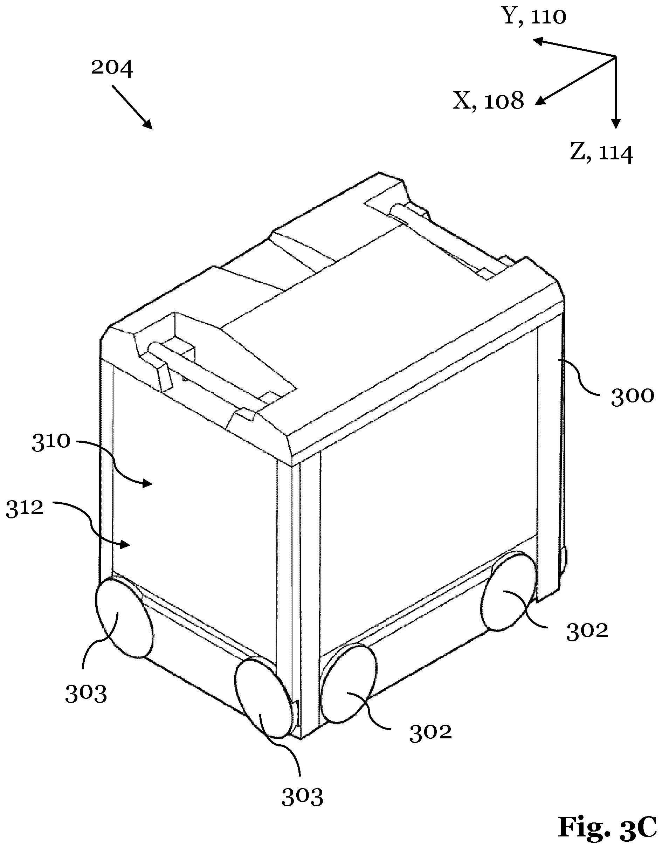

Fig. 3C shows a perspective side view of the robot of Fig. 3B in which the first set of wheels 302 from Fig. 3B are visible. The additional set of wheels referenced above but not shown in Fig. 3B are shown as wheels 303 in Fig. 3C. The additional set of wheels 303 is arranged perpendicular to the first set of wheels 302, to allow rolling of the robot 204 in the X and Y directions on the first and second set of wheels 302, 303 respectively. The first and second set of wheels 302, 303 shown in Fig. 3C may be configured to be independently lowered into engagement with the rails (and conversely raised out of engagement with the rails) to allow the robot 202 to move in the X and Y direction across the arrangement of rails shown in Fig. 2. Although the perspective view shown in Fig. 3C is of the robot 204 of Fig. 3B, it will be appreciated that a similar perpendicular wheel arrangement may be applied to the robot 202 of Fig. 3A.

### Control and monitoring system

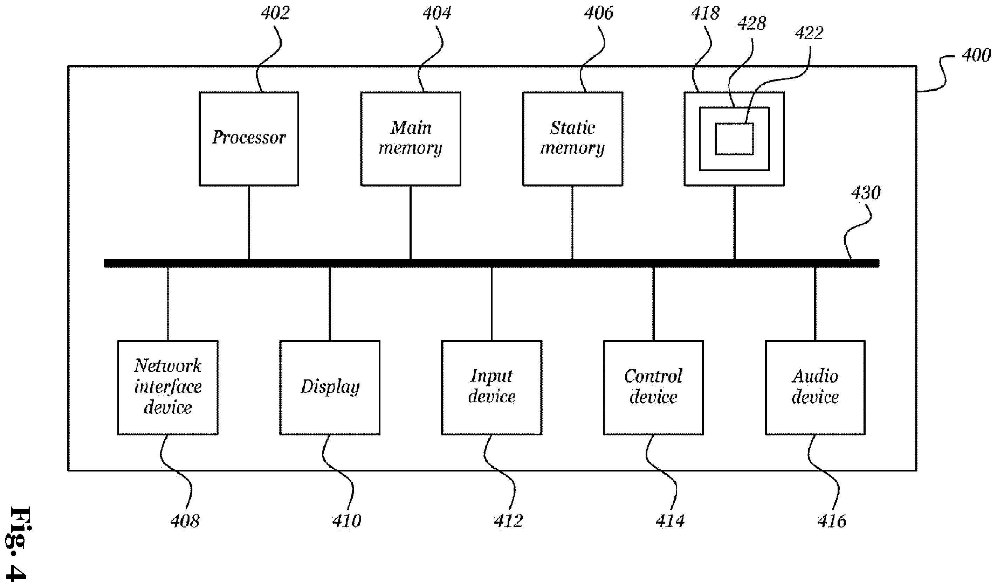

Control and monitoring of the automated storage and retrieval system, including monitoring and storing bin position and controlling bin delivery, retrieval and transport and robot routing and collision avoidance, is performed by a control system shown in Fig. 4 in communication with the robots and/or other controllable system components. Control can be performed locally or remotely and may be implemented by a processing system, for example in the form of a computing device. Accordingly, the methods described herein may form all or part of a computer-implemented method, or a system configured to perform the methods described herein.

With reference to Fig. 4, a processing system 400 suitable for carrying out the methods described herein will now be described. Fig. 4 shows a block diagram of one implementation of a processing system 400 in the form of a computing device within which a set of instructions for causing the computing device to perform any one or more of the methods described herein may be executed. In some implementations, the computing device may be connected (e.g., networked) to other machines in a Local Area Network (LAN), an intranet, an extranet, or the Internet. The computing device may operate in the capacity of a server or a client machine in a client-server network environment, or as a peer machine in a peer-to-peer (or distributed) network environment. The computing device may be a personal computer (PC), a tablet computer, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine. Further, while only a single computing device is illustrated, the term 'computing device' shall also be taken to include any collection of machines (e.g., computers) that individually or jointly execute a set (or multiple sets) of instructions to perform any one or more of the methods described herein.

The example processing system 400 includes a processor 402, a main memory 404 (e.g., read-only memory (ROM), flash memory, dynamic random-access memory (DRAM) such as synchronous DRAM (SDRAM) or Rambus DRAM (RDRAM), etc.), a static memory 406 (e.g., flash memory, static random-access memory (SRAM), etc.), and a secondary memory (e.g., a data storage device 418), which communicate with each other via a bus 430.

Processor 402 represents one or more general-purpose processors such as a microprocessor, central processing unit, or the like. More particularly, the processor 402 may be a complex instruction set computing (CISC) microprocessor, reduced instruction set computing (RISC) microprocessor, very long instruction word (VLIW) microprocessor, processor implementing other instruction sets, or processors implementing a combination of instruction sets. Processor 402 may also be one or more special-purpose processors such as an application specific integrated circuit (ASIC), a field programmable gate array (FPGA), a digital signal processor (DSP), network processor, or the like. Processor 402 is configured to execute the processing logic (instructions 422) for performing the operations and steps described herein.

The processing system 400 may further include a network interface device 408. The processing system 400 also may include any of a video display unit 410 (e.g., a liquid crystal display (LCD) or a cathode ray tube (CRT)), an alphanumeric input device 412 (e.g., a keyboard or touchscreen), a cursor control device 414 (e.g., a mouse or touchscreen), and an audio device 416 (e.g., a speaker).

It will be apparent that some features of the processing system 400 shown in Fig. 4 may be absent. For example, the processing system 400 may have no need for display device 410 (or any associated adapters). This may be the case, for example, for particular server-side computer apparatuses which are used only for their processing capabilities and do not need to display information to users. Similarly, user input device 412 may not be required. In its simplest form, processing system 400 comprises processor 402 and main memory 404.

The data storage device 418 may include one or more machine-readable storage media (or more specifically one or more non-transitory computer-readable storage media) 428 on which is stored one or more sets of instructions 422 embodying any one or more of the methods or functions described herein. The instructions 422 may also reside, completely or at least partially, within the main memory 404 and/or within the processor 402 during execution thereof by the processing system 400, the main memory 404 and the processor 402 also constituting computer-readable storage media 428.

The various methods described herein may be implemented by a computer program. The computer program may include computer code arranged to instruct a computer to perform the functions of one or more of the various methods described herein. The computer program and/or the code for performing such methods may be provided to an apparatus, such as a computer, on one or more computer-readable media or, more generally, a computer program product. The computer-readable media may be transitory or non-transitory. The one or more computer-readable media could be, for example, an electronic, magnetic, optical, electromagnetic, infrared, or semiconductor system, or a propagation medium for data transmission, for example for downloading the code over the Internet. Alternatively, the one or more computer-readable media could take the form of one or more physical computer-readable media such as semiconductor or solid-state memory, magnetic tape, a removable computer diskette, a random-access memory (RAM), a read-only memory (ROM), a rigid magnetic disc, or an optical disk, such as a CD-ROM, CD-R/W or DVD.

The computer program is executable by the processor 402 to perform functions of the systems and methods described herein.

In an implementation, the modules, components, and other features described herein can be implemented as discrete components or integrated in the functionality of hardware components such as ASICS, FPGAs, DSPs, or similar devices.

A 'hardware component' is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may be or include a special-purpose processor, such as a field programmable gate array (FPGA) or an ASIC. A hardware component may also include programmable logic or circuitry that is temporarily configured by software to perform certain operations.

Accordingly, the phrase 'hardware component' should be understood to encompass a tangible entity that may be physically constructed, permanently configured (e.g., hardwired), or temporarily configured (e.g., programmed) to operate in a certain manner or to perform certain operations described herein.

In addition, the modules and components can be implemented as firmware or functional circuitry within hardware devices. Further, the modules and components can be implemented in any combination of hardware devices and software components, or only in software (e.g., code stored or otherwise embodied in a machine-readable medium or in a transmission medium).

### Operation of the automated storage and retrieval system

In operation, each bin 112 is given a unique identifier, which may be marked on the bin 112 using a computer-readable identifier (e.g., a barcode, quick-response code or radio-frequency identification tag) to ease identification of the bin 112. A database of the processing system 400 stores, in association with the unique identifier, the position and, optionally, content of each bin 112. When a bin 112 is moved (e.g., when it is retrieved from the grid 100), the database is updated to record its change in position.

When it is desired to retrieve a bin 112 from the grid 100, under control of the processing system 400, a robot 202, 204 is routed via the rail system 116 to the vertical column 102 including the storage cell where, according to the database, the bin 112 is positioned, and the lifting device 304, 312 is positioned (according to robot type) over the corresponding access opening 124, either adjacent or below the robot 202, 204. The robot 202, 204 lowers the gripping device 308 which engages, grips and lifts the bin 112 to the robot 202, 204. The robot 202, 204 then transports the bin 112, for example, to the drop-off port column 126, 128 for delivery to the port 130, 132 and subsequent processing external to the grid 100. In the event that the target or designated bin 112 is below other bins in the stack then the robot 202, 204 or multiple robots, which may be dedicated to the task, are controlled in a 'digging' operation to sequentially lift and reposition, temporarily or permanently, bins above the target bin 112 in order for it to be retrieved. It will be appreciated that other operations in relation to the bin 112 can be carried out in a similar manner. For example, a bin 112 can be delivered for storage in the grid 100 at the port 130, 132 of the pick-up port column 126, 128, gripped and lifted by a robot 202, 204 and delivered to the desired storage cell, bins above the desired position being repositioned if necessary as discussed above.

### Description of specific improvements

### Floor flatness

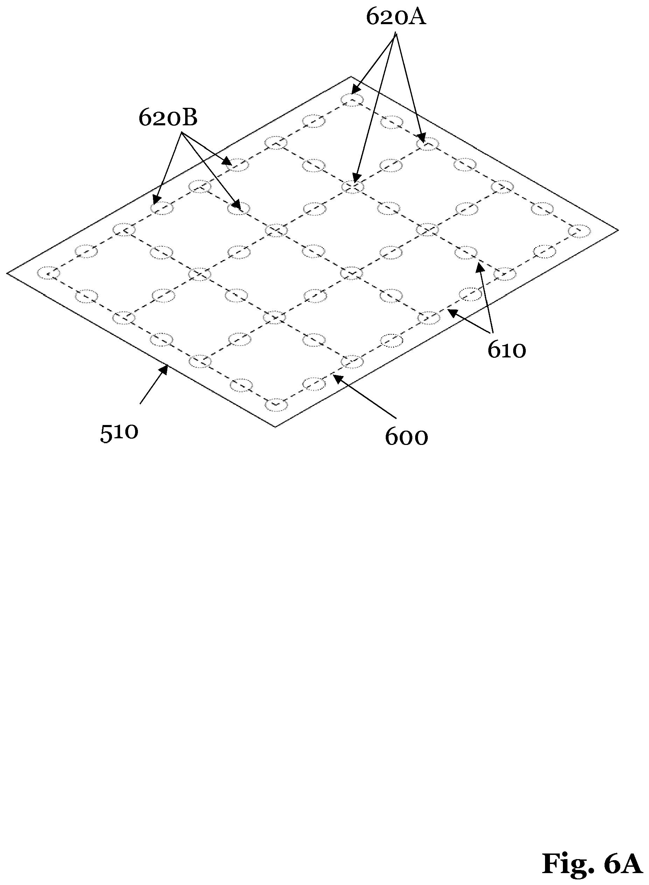

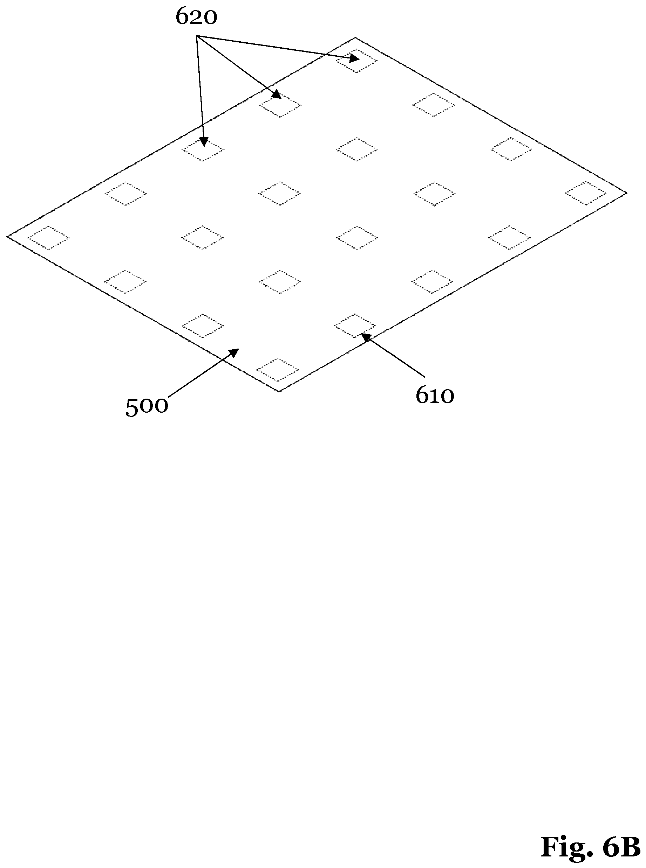

Referring back to Fig 1, the grid 100 is typically supported on a floor, such as a warehouse floor. The grid makes contact with the floor, and is generally supported by the floor via a number of different elements of the grid. In some examples, the grid is supported on horizontal floor rails that rest on, and may be anchored to the floor. For example, one or more vertical frame members 104 may be coupled at their base to one or more horizontal floor rails (not shown in Fig. 1). In addition, or as an alternative, vertical frame members 104 may be directly in contact with, supported by and optionally anchored to the floor without intermediate floor rails. Some examples of the interface between a grid and the floor are indicated in Figs. 6A and 6B, which are described in more detail below.

In many real-world scenarios, a floor designated for installation of an automated storage and retrieval system with a storage grid 100 is not perfectly flat. In general, the floor may have deviations in its height comprised of protrusions and recessions. Across the floor span covered by a large storage grid 100, those deviations in the floor height or flatness may lead to issues with the installation and operation of the storage grid. This is particularly relevant to height deviations located at the points of the floor at which the grid is supported.

To address the problem of installing storage grids upon floors that are not perfectly flat, the present disclosure provides a method that identifies any height deviations in the floor at the contact points between the floor and the grid, in order to produce a specification that specifies that magnitude and location of each height deviation at those contact locations. The specification may specify, or may be used to determine, the necessary height compensating means for each contact point, so that the height compensating means can be installed during installation of the storage grid, so that the storage grid is installed on a flat surface.

### 3D floor model

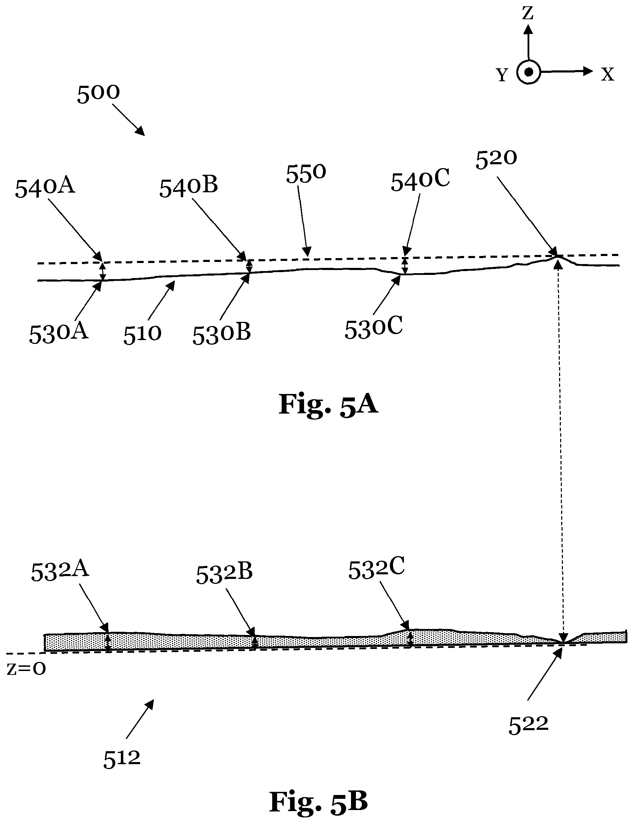

Referring now to Fig. 5a, a side-view of a 3D model 510 of a floor 500 designated for installation of a storage grid is shown. The 3D model is depicted from a side-view (i.e., viewed along the y axis) in order to clearly illustrate height deviations in the floor (in other words, the deviations from a perfectly flat floor). In general, and consistent with the description of Fig. 1, a floor is considered to generally span the x-y plane and the deviations are described in terms of the z axis. In other words, x and y lie horizontally whilst z lies vertically.

The 3D model of the floor may be obtained using a 3D scanning system, such as a LiDAR scanning system that scans the actual floor 500 and records a plurality of spatial data points representing the floor. The plurality of spatial data points collectively form a 3D "cloud" of points, otherwise known as a point cloud. The point cloud recorded by the scanning system may be stored in computer memory in the form of an appropriate data structure, which may be retrieved from the memory, rendered and displayed via a user interface to depict the 3D point cloud representing the floor. The 3D point cloud representing the floor may be referred to herein as the 3D model of the floor. In general, any suitable means that is apparent to the skilled person and that is appropriate for obtaining a 3D model of the floor may be used. In addition, any suitable means for rendering and displaying the 3D model may be used.

As would be appreciated by the skilled person, the 3D model may be rendered and displayed via a user interface provided by an application running on a user device (such as a personal computer, laptop, tablet, phone etc.). Due to its three-dimensional nature (in particular the z-axis components arising due to the floor not being perfectly flat and instead exhibiting protrusions and/or recessions), the 3D model may be displayed from a plurality of different viewpoints to identify various features (such as height deviations) in the floor. Referring back to Fig. 5A, the side-on view (viewed along the y axis, although a view along the x axis or any other horizontal axis is also suitable), clearly demonstrates deviations from a perfectly flat floor as shown in the figure.

In more detail, the side-view of the model 510 shown in Fig. 5A shows the highest point 520 of the floor, in addition to other smaller protrusions, recessions and sloped portions. In general, Fig. 5A shows that the height of the floor, or the z coordinate for the floor, varies in the x direction. The same may also be true for the y direction although this is not shown for brevity. As discussed above and in more detail below, compensating for the variation in the height of the floor (i.e., the height or flatness deviations) generally involve means to compensate for those points (e.g., the points that the grid will make contact with the floor) that are at a lower height than a highest point of the floor. This means providing a height compensating means at each point lower than the highest point, such that the grid may be effectively supported on a flat surface situated at the height of the highest point. As such, identifying the highest point of the floor may form part of the method in some embodiments, so that the amount of height compensation for all other points can be determined relative to the highest point.

In some embodiments, the highest point 520 from which to compensate for all other points may be the absolute highest point of the entire floor which may be determined from a straightforward analysis of all data points of the 3D model 510 of the floor 500. For example, the spatial data point with the greatest height coordinate (the data point with the highest value z coordinate) can be identified. The value of the z coordinate for that point is then used as the reference from which to determine the height compensation for all other points as described below.

In other embodiments, the highest point 520 from which to compensate for the height deviation of all other points may be taken to be the highest point of the set of points at which the storage grid 100 will make contact with the floor 500 when the grid is installed. In other words, the highest point may be taken to be the highest point from the set of contact points, where the set of contact points is defined as the set of points of the floor that will make contact with the grid when installed. As discussed below with reference to Figs. 6A and 6B, the grid may only make contact with a small portion of the floor (e.g., via horizontal floor members or vertical frame members), and so the highest absolute point of the floor may not lie within the contact points. As such, in some embodiments, the highest point is determined as the highest contact point (i.e., the contact point with the highest value z coordinate). Identifying the highest contact point may involve overlaying a model of the grid 100, or at least a base portion of the grid 100, on the 3D model 510 to determine which points of the floor are to make contact with the grid. From that overlay, the highest point from identified set of contact points can be determined by straightforward analysis of the z coordinates of all contact points as described above.

In either case (whether the highest absolute point or the highest contact point is used as the reference height from which to determine the height compensation for all other points), the determined highest point is used as the reference point from which an effective flat surface is provided for supporting the grid. In this way, modifications to the floor are not necessary since height compensating means such as shims or height adjustable elements may be used at each contact point in order to make up the height difference.

After identifying the highest point (highest absolute point or highest contact point), the height deviations for every other point relative to that point may be determined. Referring back to Fig. 5A, height deviations for a subset of points 530A-C are indicated by the small double-edged arrows 540A-C respectively. The arrows 540A-C represent an amount of height compensation required for the respective point, which is equal to the height difference (i.e., the difference in the z coordinate) between that point and the highest point. This difference in height is the amount of compensation required to provide a flat supporting surface at the height of the highest point, which is indicated in Fig, 5A by the dashed line 550. The dashed line 550 represents a horizontal reference plane at the height of the highest point. This reference plane in effect represents the intended flat supporting surface for the grid. To provide this surface as described in more detail below, the difference in height between each point and that reference surface, aka the magnitude of the deviation must be accounted for using height compensating means such as shims or other height adjustable elements.

In some embodiments, the height difference relative to the highest point is determined only for the set of contact points. As described above, some embodiments may involve overlaying a model of the grid 100 or the base of the grid 100 onto the 3D model 510 of the floor in order to identify the x and y coordinates of the contact points, i.e., the points of the floor that will support the grid 100 when the grid is installed. More generally, any suitable technique for identifying the regions or points of the floor that will make contact with the grid may be used. Once the set of contact points and the highest point (e.g., highest contact point) have been identified, the magnitude of the height difference (which equates to the amount of height compensation needed) between the highest point and each contact point may be determined. As an example and with reference to Fig. 5A, a set of contact points in one example may consist of the highest point 520 and each of the points 530A, 530B and 530C. To provide a flat surface at the height indicated by the dashed line 550 (a surface at the height of the highest point 510) for supporting a storage grid 100, the magnitude of the height deviations indicated by arrows 540A, 540B and 540C must be determined by determining the height difference between each contact point 530A, 530B and 530C and the highest point 510. As described in more detail below, the determined height difference may then be used to specify the height compensating means for each contact point 530A, 530B and 530C.

In general, the result of identifying the highest point, identifying the contact points between the floor and the storage grid, and determining the height differences between each contact point and the highest point is that the magnitude of the height differences between each contact point and the highest point may be compiled into an installation specification. As described in more detail below, the installation specification details the height compensation and optionally the exact height compensation means for each contact point to aid in the installation process.

### 3D inverted model

Referring now to Fig. 5B, an inverted 3D model 512 that corresponds to the 3D model 510 of Fig. 5A is shown. As can be seen from the figures, the inverted model 512 is based on an inversion of the z coordinate of every point in the original 3D model 510. In more detail, the z coordinate in each point of the inverted model 512 is based on reflection of the corresponding point (i.e., the same x and y coordinates) in the original model 510 in a horizontal plane, which may be set at the height of the highest point 510 (which may be the highest absolute point or the highest contact point as described above). In other words, to obtain the inverted model, the original model is reflected in a horizontal plane to invert the height profile of the model. Following the reflection, the z coordinates of each point may be translated by the same amount in order to set the z coordinate of the highest point as zero. For example, if the horizontal plane in which each point is reflected is the x-y plane (x = 0, y= 0), the translation in z will be a positive shift by an amount equal to the z coordinate of the highest point in the original model 510. If the horizontal plane in which each point is reflected is a horizontal plane set at the z coordinate of the highest point, then the translation in z will be a negative shift by an amount equal to the z coordinate of the highest point in the original model 510.

The result is that in the inverted 3D model 512, the z coordinate of each point directly equates to the amount of height compensation for the corresponding point (i.e., the point with the same x and y coordinates) in the original 3D model 510. In other words, the z coordinate of each point in the inverted 3D model 512 equates to the height difference between the corresponding point and the highest point in the original 3D model. Referring back to Fig. 5B, the inverted model is shown with the line of z=0 (i.e., the x axis in this view). Thus, at the point 522 (which corresponds to the highest point 520 in the original model 510), the z coordinate in the inverted model is zero. At the point 532A, which corresponds to the point 530A in the original 3D model 510, the z coordinate is equal to the height difference between the point 530A and the highest point 520 in the original model. The same is true for points 532B and 532C, which correspond to points 530B and 530C respectively. The double-edged arrows shown for each point 532A, 532B, 532C thus correspond in size to the same arrows shown for points 530A, 530B and 530C.

Therefore, the 3D inverted model provides an alternative method for determining the magnitude of the height deviations for different points of the original floor 500 relative to its highest point 520. In some embodiments, the height difference between the set of contact points and the highest point can be determined using the inverted 3D model by overlaying a model indicating the base of the storage grid onto the inverted 3D model to identify the positions in x and y of the contact points, and to read off directly from the inverted model the z coordinate for each contact point, which represents the height difference or the amount of height compensation for each contact point. As described in more detail below, the magnitude and location of the height deviations for each contact point may be compiled into an installation specification to aid with the installation of the storage grid on a flat support surface.

### Installation Specification

As described above, after determining the location and magnitude of the height deviations for each point of the floor that will be in contact with the grid, a specification is compiled based on the height deviations. In particular, the specification specifies, for each contact point, the height difference between the floor at that contact point and the highest point. In other words, the specification specifies the amount of height compensation required for each contact point in order for the grid to be installed on a flat support surface. The specification may take the form of a document, such as an electronic document, or a database, or a table or any suitable form that appropriately presents the necessary information concerning the location and magnitude of the height deviation for each contact point.

In some embodiments, the specification may further include details of the specific height compensation means to be used during installation of the storage grid in order to account for the height deviations at each contact point. In one example, the height compensating means may comprise shims (also known as spacers) that are placed between the storage grid and the floor at the contact points. For each contact point, the specification may specify the exact number and/or size of shims required to account for the height deviations in the floor at that contact point. In other words, the specification may include a bill of materials (BoM) that specifies the number and/or size of shims required for each contact point. In some examples, the shims may be standardised, readily available, mass produced shims of fixed sizes that can be vertically stacked on top of one another. In one particular example, standardized shim sizes of 1mm, 2mm, 5mm, 10mm and 20mm may be available and the height deviation at each contact point is accounted for using combinations of these shims stacked together. For instance, for a contact point with a height deviation of 7mm, the specification may state that 1x 5mm shim and 1x 2mm shim should be used. For a contact point with a height deviation of 4mm, the specification may state that 2x 2mm shims should be used. In general, the specification may state that any combination of shims may be used to account for any size height deviation.

In some examples, shims may be made-to-order according to the height deviation at each contact point, in which case the specification may state the specific size of shim to be placed at each contact point. Taking the example described in the preceding passage, the specification may list 1z 7mm shim for the first contact point and 1x 4mm shim for the second contact point.

In other examples, the height compensation may be provided by height adjustable elements, such as height adjustable feet supporting the vertical frame members or horizontal floor rails of the grid. Such height adjustable feet are disclosed and described in European application EP25154841.8, which is incorporated herein by reference in its entirety. The height adjustable feet are described in more detail below and with reference to Figs. 8A - 8D and 9A - 9D. In such examples, the specification may include details of the exact amount of height adjustment for the height adjustable elements of the grid that will be located at the contact points when the grid is installed. The amount of height adjustment may be provided in terms of a length measurement (e.g., 7mm, 4mm, etc) or in terms of a parameter specific to the exact height adjustable element. As a non-limiting example, the height adjustable element may include a ratchet-type mechanism that has 1mm increments. In such an example, the specification may state a number of increments for each contact point.

An example of a height adjustable element for use with the present disclosure (for providing the height compensation determined as described above) is provided in Figs. 8A - 8D and is now described. It would however be appreciated that other height adjustable elements may be used instead of the exemplary feet described herein. Each height adjustable foot device comprises four distinct parts 602, 604, 607, 603, labelled as follows: 1) a lower foot component 602, which may be a female foot component 602; 2) an upper foot component 604, which may be a male foot component 604, designed to threadedly engage with the lower/female foot component 602; 3) a lower wedge part 607; and, 4) an upper wedge part 603, which can be alternatively referred to as a height-adjustable upper component 603.

The lower and upper foot components 602, 604 together form a height-adjustable foot 606. The lower and upper wedge parts 607, 603 together form a wedge device. In the described arrangement, each height-adjustable foot device comprises both a height-adjustable foot, at the bottom, which is the part designed to rest on the floor, and a (also height-adjustable) wedge device, which is instead designed to sit on a corresponding grid base rail, just above the height-adjustable foot.

Figure 8A shows in more detail features of the height-adjustable upper component 603. It has a top, generally rectangular-shaped portion 833 designed for insertion into, and interference coupling with, a lower end of an upright member of the grid. A peripheral wall 834 surrounds the rectangular-shaped top portion 833. From it, two sets of two parallel wings 835 extend perpendicularly on either of the rectangle's long sides, as shown. At the bottom, a flange 832 surrounds the top rectangular portion 833, and it also extends at right angles with respect to said peripheral wall 834, and also perpendicularly with respect to the wings 835. This component 603 is hollow inside, with a recess 836 which may be accessed from the bottom end, just below the flange 832, which recess 836 is designed for coupling with the corresponding tubular projection 601 at the top end of the upper foot component 604. Finally, though this is not visible from Fig. 8A due to the angle of the perspective, this component 603 may also have a lower inclined surface 831 for mating with a corresponding inclined surface 820 provided on the lower wedge part 607, as mentioned above, and as further described below. Said inclined surfaces 820, 831 together form a slope or inclined plane interface, which enables the height-adjustability of the wedge device (when present).

Fig. 8B shows the features of the lower wedge part 607. We have already described its top inclined surface 820, which extends at the top of two prongs 821 of a generally U-shaped design for this part 607. Internally, on inward-looking faces of said prongs 821, corresponding sets of first teeth 822 are provided for engaging with complementary sets of second teeth 811 provided around the top tubular projection 601 of the upper foot component 604, as further described below.

Fig. 8C shows the features of the upper foot component 604. At the bottom end, a male threaded cylinder 802 is provided, for insertion and threaded engagement into the lower foot component 602. A flat portion 810 is provided just above the threaded cylinder 802, which will be normally used for supporting and locally levelling a grid base rail at a required horizontal height. Projecting upwards from said flat portion 810, are four pins 813, as shown. The pins 813 are also configured to engage corresponding apertures provided on the base grid rail for receiving the upper foot component 604. Projecting upwards from said flat portion 810 is also the known top tubular (and generally rectangular) projection 601, which, just like the four pins 813, is also designed for engagement with a corresponding aperture on the grid base rail. This projection 601 includes on opposite long sides thereof the second set of teeth 811 described above, which project from and a surrounding wall 812 of generally rectangular shape which extends perpendicular from said flat portion 810. A recess 815 is provided on the projection 601, as shown. Finally, a small detent 814 is formed on said upwardly extending wall 812, which may work as a guiding feature for receiving a corresponding guiding feature provided in the recess 836 of the height-adjustable upper component or upper wedge part 603.

Moving on to Fig. 8D, the lower foot component 602 has a generally circular base 803 with indents 804 which may be used for fixing the circular base 803 to the floor, for example using screws or bolts (not shown). Before the circular base 803 is filed to the floor, the indents 804 may be used for engaging with corresponding projections provided on a height-adjustment key for rotating the circular base 803 circumferentially, so as to adjust the level of the upper foot component 604 on the lower foot component 602. A set of six wings or winglets 805 project from a circular body wall 806 of the lower foot component 602, which extends upwardly at right angles from the circular base 803. Inside said circular body wall 806 a female thread 801 is configured for engagement with the male thread of the threaded cylinder 802 of the upper foot component 604.

Once in place on the floor, the height of each height-adjustable foot device 801 may be adjusted by rotating the lower foot component 602, so as to change the relative distance between this component 602 and the upper foot component 604 situated thereon. This changes the height of the flat portion 810 on which a portion of the grid base rail is supported, at the location of the height-adjustable foot device.

Fig. 9A shows a slight constructional variation of the height-adjustable foot devices described herein. The height-adjustable foot device of Figure 9A still comprises adjustable lower and upper foot components 602, 604, but in addition it also includes a rotatable threaded nut 901, as shown, which may be rotated for adjusting the relative distance of the two components 602, 604. In addition, the base 803 is no longer circular, but circular at the centre and elongated in to opposite directions. Further, the indents 904 are replaced by small hollow cylinders 804 projecting upwards from said base 803, as shown in Fig. 8A, which are still suitable, however for mechanical engagement for rotating the base 803, or for fixing it to the floor.

Figs 9A-B also show another slight constructional variation in that the height-adjustable foot device now shown only has a pair of opposed wing supports 910 by which the flanges 820 of the grid base rails 803 are supported, in use. On the contrary, other implementations of foot devices have four opposed wing supports 910, two on each side of the foot device, compatible with the height-adjustable foot 806 shown in Fig. 9D.

Fig 9C implements the height-adjustable foot 606 (that is the lower half of a complete height-adjustable foot device as described herein) as a wedge device, via inclined interface 903, as shown. This is another possibility for implementing a height-adjustable foot 606 within the present requirements, as will be appreciated by the skilled person.

In other examples, the grid may be designed with purpose built vertical frame members that correspond to different contact points and that each have a length corresponding to the height deviations at the respective contact point. In such examples, the specification may specify which vertical frame member is to be used in which specific location (i.e., in the location of its corresponding contact point). Each vertical frame member may be indexed along with its respective contact point such that they can be matched and placed correctly during installation.

In general, the specification may specify any means appropriate to the skilled person for positively making up the difference in height between the contact point and the reference flat support surface positioned at the height of the highest point.

### Grid contact points

With reference now to Figs. 6A and 6B, two exemplary depictions of a grid overlay 600 on a 3D model 510 of a floor 500 are shown in a perspective view. In the first example shown in Fig. 6A, the grid is supported by a plurality of horizontal floor rails, which are indicated in the figure by the array of dashed lines 610. The grid overlay 600 on the 3D model 510 indicates the exact location of the horizontal floor rails 610 relative to the floor to show exactly where the horizontal rails will make contact with the floor. As described above with reference to Figs. 5A and 5B, a set of contact points can therefore be determined for which to compensate for height deviations in the floor, so that the grid may be installed on a substantially flat supporting surface.

In some examples, the set of contact points may be determined to be every single point of the floor covered by the horizontal floor rails 610 (i.e., every point of the floor covered by the dashed line array in Fig. 6A). In other examples, a smaller set of contact points may be determined. Fig. 6A illustrates one particular example of a set of contact points 620 indicated by the dashed circles. In this particular example, the set of contact points 620 is made up of the positions of the floor at which the horizontal rails meet or intersect (indicated by circles 620A) and the positions at the midpoint between each intersection (indicated by circles 620B). This exemplary set of contact points 620 (made up of points 620A and 620B) thus define the positions of the grid 100 that are supported on the floor 500, and correspondingly define the exact points of the floor 500 that are to provide the support for the grid 100. Using the techniques described above, the height deviations for each identified contact point can be determined (e.g., by finding the highest contact point and finding the height difference for each other contact point relative to the highest contact point) in order to produce the specification. Identifying a set of contact points in this manner using the overlay 600 of the grid on the 3D model 510 therefore reduces the complexity and computational resources required to address height deviations in the floor, since the deviations only need to be determined for those supporting points where grid is to be supported on the floor.

Referring to Fig. 6B, an alternative example of a set of contact points 620 are illustrated by dashed squares. In this example, the grid is supported by a plurality of vertical frame members that make direct contact with the floor as indicated by the dashed squares 610. Each dashed square represents the position of a vertical frame member and thus indicates the exact location that each vertical frame member will make contact with the floor. In this example, the set of contact points 620 consists of the positions of every vertical frame member 610, so that height deviations in the floor 500 where every vertical frame member rests can be accounted for using the techniques described above. In particular, the highest contact point of the set 620 (the highest contact point corresponding to a vertical frame member 610) can be found before finding the height difference for each other contact point relative to the highest contact point in order to produce the specification. In this way, each vertical frame member of the grid can be supported on a substantially flat support surface by providing the appropriate height compensating means beneath each vertical frame member.

### Example method

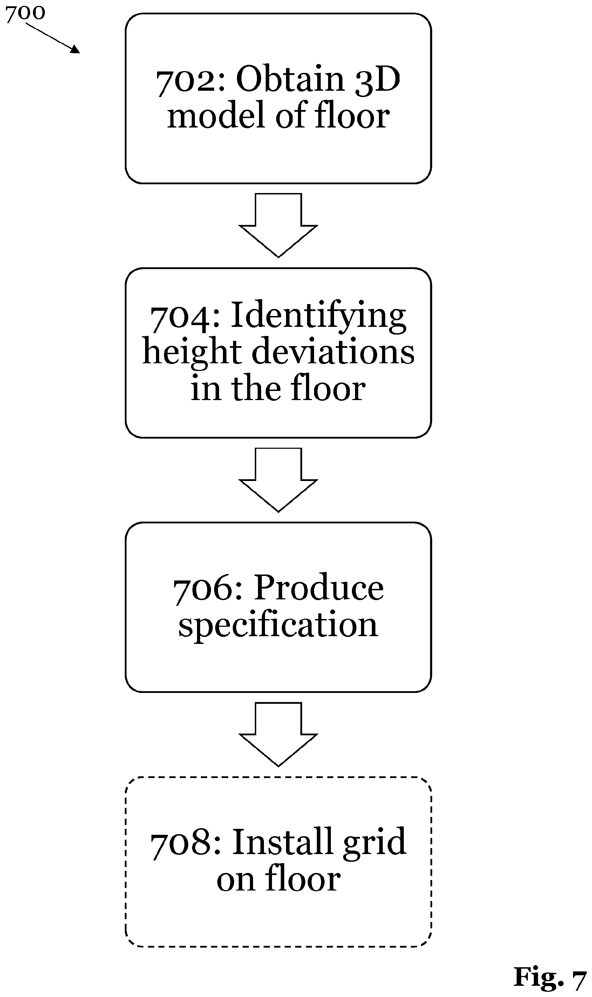

With reference to Figure 7, an example method 700 according to the present disclosure is shown. The method 700 comprises a first step 702 of obtaining a 3D model of a floor. The floor may be designated for installation of a storage grid of an automated storage and retrieval system and may have been scanned using any suitable 3D scanning system, such as a LiDAR system, to generate the 3D model of the floor. The 3D model may thus comprise a plurality of spatial data points in the form of a point cloud that represents the surface of the floor, and which indicates height variations across the floor's surface. Obtaining the 3D model according to step 702 may comprise carrying out the 3D scan, or may comprise retrieving a previously recorded 3D scan from computer memory.

The method 700 further comprises a step 704 of identifying one or more points of height deviation in the floor. In more detail, identifying points of height deviation in the floor involves analysing the 3D model of the floor to identify and record points of deviation in the height or flatness of the floor. As described above in relation to Figs. 5A and 5B, step 704 may be carried out by identifying the highest point of the floor using the 3D model, and determining a height difference between said highest point and one or more contact points of the floor that will be in contact with the storage grid when the grid is installed. The magnitude of the height difference between the highest point and each contact point represents the amount of height compensation required for that contact point. In other examples, step 704 may be carried out by generating an inverted 3D model of the floor which represents in its height coordinate the height compensation required for every point of the floor relative to the highest point. Based on the inverted 3D model, the amount of height compensation for one or more contact points can be determined directly from the height coordinate of the corresponding point in the inverted model as described above.

After obtaining the magnitude and location of the identified points of deviation according to step 704, the method proceeds to step 706 at which a specification is produced containing the magnitude and location of each identified point of deviation. As described above, the specification may further contain details of the amount of height compensation required relative to an identified highest point and may also contain details of the height compensating means to be used during installation for each contact point. For example, the specification may specify the number and size of shims to be used at each contact point according to the required amount of height compensation at that contact point.

In some embodiments, the method 700 may further comprise an optional step 708 of installing a storage grid on the floor according to the specification. In more detail, the step of installing the grid may involve providing the necessary height compensating means at each contact between the grid and the floor, and/or adjusting a height compensating means as necessary according to the amount of height compensation required at any given point, where the amount of compensation is specified by the specification. In some examples, this may involve placing the right size and/or number of shims between the floor and the grid at the contact points according to the specification, or adjusting the height of height adjustable elements positioned at each contact point. This may involve adjusting the height of height adjustable feet placed beneath horizontal floor rails or vertical frame members of the grid according to the specification. In some examples, this may involve adjusting the length of vertical frame members located above each contact point according to the specification.

In some embodiments, installing the grid may involve the use of a visual aid to visualise the installation process. For example, a graphical depiction of the specification may be used which provides details of the amount of height compensation required for each contact point between the grid and the floor. The graphical depiction of the specification may illustrate the grid and the position of each contact point on a depiction of the floor (similar to the depiction of Figs. 6A or 6B which show an overlay of the grid on the floor and which highlights each contact point between the grid and the floor). For each contact point the graphical depiction may include the height deviation/amount of height compensation at that point, as well as information relating to the specific height compensating means to be used at that point. For example, each contact point may be labelled with the amount of height compensation, such as "3mm", "10mm", "1mm" and so on. The graphical depiction may also specify the type and/or number of shims to be used for each contact point using labels, such as "1x 2mm shim and 1x 1mm shim", "2x 5mm shims" and "1x 1mm shim" to aid with installation of the grid. In this way, the specification may be used as instructions to those installing the grid so that the installers are able to correctly provide the right amount of height compensation at each contact point in order to provide the effect of a substantially flat surface upon which the grid rests.

In some examples, the visual aid may be interactively displayed on a computer, smartphone, tablet, or the like, such that an operator may interactively view the floor with specification information overlaid thereon, and to highlight or select any given contact point in order to determine the height compensation means to be used at that contact point. Further still, the graphical depiction of the specification may be overlaid on an image or video of the actual floor designated for installation, so as to produce an augmented-reality display of the space in which the grid is to be installed, which includes the necessary information for how to install the grid according to the specification. In other words, a graphical depiction of the specification may be overlaid, using AR techniques, a live view of the floor to provide a real-world indication of the positions of each contact point between the grid and the floor, and the amount and type of height compensation that has been determined for each contact point. Any suitable means may be used to provide the augmented reality display, such as an AR headset, holographic systems, head-up displays, or any other suitable means apparent to the skilled person.

It is to be understood that the above description is intended to be illustrative, and not restrictive. Many other implementations will be apparent to those of skill in the art upon reading and understanding the above description. Although the present disclosure has been described with reference to specific example implementations, it will be recognized that the disclosure is not limited to the implementations described, but can be practiced with modification and alteration within the spirit and scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

There is further provided the following embodiments:
1. A grid base for an automated storage and retrieval system comprising a plurality of vertically extending structural upright members disposed to form a storage grid defining a plurality of vertically extending storage columns within each of which one or more storage containers may be stacked, the grid base comprising:
   a plurality of foot devices configured to support said grid base over a floor; and,
   a plurality of grid base rails each extending in a longitudinal direction,
   wherein the grid base rails are supported on said plurality of foot devices over said floor, and each foot device is supported on said floor.
2. The grid base of clause 1, wherein one or more of the plurality of foot devices are height-adjustable foot devices.
3. The grid base of clause 1 or 2, wherein the plurality of grid base rails are arranged parallel one another.
4. The grid base of clause 1, 2 or 3, wherein the grid base rails are configured to support, in use, said one or more storage containers.
5. The grid base of any one of clauses 1 to 4, wherein the grid base is supported at a distance above said floor, wherein said distance is at least 1 cm or at least 5 cm or at least 10 cm or at least 15 cm or at least 20 cm.
6. The grid base of any one of clauses 1 to 5, wherein the grid base is configured such that the plurality of foot devices corresponds to said plurality of vertically extending structural upright members, respectively;
   optionally, wherein the grid base is configured such that each of the foot devices is located, in use, under a respective one of the vertically extending structural upright members.
7. The grid base of any one of clauses 1 to 6, wherein each grid base rail defines at least one foot-device mating feature arranged to receive, or to be received by, a respective one of the foot devices;
   optionally, wherein said foot-device mating feature comprises one or more apertures configured to receive corresponding one or more projections defined by said foot device;
   alternatively, wherein said foot-device mating feature comprises one or more portions configured to be received in corresponding one or more recesses provided on said foot device.
8. The grid base of any one of clauses 1 to 7, wherein each grid base rail defines at least one spacer-coupling feature arranged to receive, or to be received by, a respective spacer for spacing the grid base rails;
   optionally, wherein said spacer-coupling feature comprises one or more openings or slots configured to receive corresponding one or more protrusions formed on said spacer;
   alternatively, wherein said spacer-coupling feature comprises one or more protrusions configured to be received in corresponding one or more openings or slots provided on said spacer.
9. The grid base of any one of clause 1 to 8, wherein the grid base rails each comprise one or more outwardly extending portions configured to receive, in use, respective one or more peripheral portions of respective one or more undersides of respective one or more storage containers, when said one or more storage containers are stored in corresponding one or more storage columns of the automated storage and retrieval system.
10. The grid base of any one of clauses 1 to 9, wherein each of the foot devices comprises a lower foot component (602) configured to be supported on said floor.
11. The grid base of clauses 9 and 10, wherein a width of the lower foot component (602) measured at the floor is greater than a gap between opposed peripheral portions of respective containers or greater than a maximum width of each of the grid base rails measured at said outwardly extending portions.
12. The grid base of any one of the preceding clauses when dependent upon clause 2, wherein each of the height-adjustable foot devices comprises at least one height-adjustable upper component (603) designed to support a weight associated with the automated storage and retrieval system.
13. The grid base of clauses 10 and 12 or of clauses 11 and 12, when dependent upon clause 2, wherein each height-adjustable foot device comprises an upper foot component (604) configured to directly and height-adjustably engage with said lower foot component (602);
   optionally, wherein said lower foot component (602) and said upper foot component (604) are directly threadedly engaged directly one to the other;
   alternatively, wherein said lower foot component (602) comprises a threaded nut (901) rotatably engaged to said lower foot component (602), and said upper foot component (604) is threadedly engaged to said lower foot component via said threaded nut (901);
   alternatively, wherein said upper foot component (604) and said lower foot component (602) define a first sloping interface (903), such as a planar inclined interface (903).
14. The grid base of any one of clauses 1 to 13, wherein at least one foot device further comprises a wedge device (609) disposed between the grid base rail and a corresponding vertically extending structural upright member,
   optionally, wherein the wedge device (609) comprises a lower wedge part (607) and an upper wedge part (603), which may optionally consist of said heigh-adjustable upper component (603).
15. The grid base of clause 14, wherein said upper foot component (604) comprises a distal end (812) configured to receive said height-adjustable upper component (603), and wherein said lower wedge part (607) and height-adjustable upper component (603) define a second sloping interface (820, 831);
   optionally, wherein said lower wedge part (607) is U-shaped.
16. The grid base of clause 13, 14 or 15, wherein the upper foot component (604) comprises one or more support portions (910, 910) configured to support an underside (605, 905) of the respective grid base rail.
17. A storage grid (100) for an automated storage and retrieval system, the storage grid comprising:
   a grid base according to any one of the preceding clauses; and
   a plurality of vertically extending structural upright members defining a plurality of vertically extending columns within each of which one or more storage containers may be stacked.
18. An automated storage and retrieval system comprising:
   the storage grid of clause 17;
   one or more storage containers each disposed within one of said vertically extending storage columns, optionally wherein two or more of said containers form stacks of storage containers in one or more of said vertically extending storage columns;
   a rail system arranged on said storage grid and comprising a first set of parallel top tracks disposed in the longitudinal direction and a second set of parallel top tracks disposed in a direction transversal to the longitudinal direction; and
   one or more wheeled container-handling vehicles adapted to travel on said rail system, the container-handling vehicles being each equipped with a gripping and lifting device for removing storage containers from the vertically extending storage columns and for replacing the storage containers in the vertically extending storage columns.
19. A kit of parts for assembling a grid base according to any one of clauses 1 to 16, or for assembling a storage grid according to clause 17, or for assembling an automated storage and retrieval system according to clause 18.
20. A method of assembling a levellable or levelled grid base according to any one of clauses 1 to 16, or for assembling a storage grid according to clause 17, or for assembling an automated storage and retrieval system according to clause 18, the method comprising:
   providing a plurality of foot devices on a floor;
   supporting a plurality of grid base rails on said plurality of foot devices, thereby forming said grid base over said floor;
   optionally, placing one or more storage containers on said grid base rails; and,
   when they are height-adjustable, adjusting a height of at least one of said foot devices.

## Claims

1. A computer-implemented method for compensating for height deviations in a floor, the method comprising:
obtaining a 3D model of the floor;
analysing the 3D model to identify one or more points of height deviation in the floor; and
producing a specification which specifies the location and magnitude of each identified point of deviation.

2. The method of claim 1, wherein obtaining the 3D model of the floor comprising scanning the floor with a 3D scanning system, optionally wherein the 3D scanning system is a LiDAR scanning system.

3. The method of claim 1, wherein obtaining the 3D model of the floor comprises retrieving recorded 3D data from computer-readable memory.

4. The method of any preceding claim, wherein the floor is intended for installation of an automated storage and retrieval system comprising a storage grid intended to be supported on the floor.

5. The method of claim 4, wherein identifying the one or more points of deviation comprises:
determining a set of contact points on the floor, wherein the set of contact points represent the locations of the floor where the storage grid will be in contact with the floor;
analysing the 3D model to identify a highest point of the floor; and
determining a height difference between each contact point and the highest point of the floor, wherein the magnitude of each point of deviation corresponds to the height difference.

6. The method of claim 5, wherein determining the set of contact points comprises overlaying a model of at least a base of the storage grid onto the 3D model of the floor, and identifying a plurality of points of contact between the floor at the base of the storage grid.

7. The method of claim 5 or 6, wherein identifying the highest point of the floor comprises identifying a contact point within the set of contact points with the greatest height coordinate.

8. The method of any of claims 5 to 7, further comprising inverting the 3D model of the floor in a horizontal plane set at the height of the identified highest point of the floor, such that the height coordinate of each point of the inverted 3D model corresponds to the height difference between that point and the highest point in the original 3D model.

9. The method of any of claims 5 to 8, wherein the specification comprises an amount of height compensation for each contact point between the floor and the storage grid and further includes one or more of:
a bill of materials specifying a number of shims required to provide the height compensation for each contact point;
an amount of height adjustment required for height adjustable elements of the storage grid corresponding to the set of contact points;
relative length information for each of a plurality of vertical frame members of the storage grid, wherein each vertical frame member corresponds a contact point.

10. The method of any preceding claim, further comprising installing a storage grid of an automated storage and retrieval system on the floor, wherein the installation comprises compensating for height deviations in the floor at each point of contact between the floor and the storage grid according to the height compensating means specified in the specification.

11. The method of claim 10, wherein compensating for the height deviations in the floor comprises one or more of:
placing one or more shims between the storage grid and the floor at each contact point, wherein the number and height of the shims placed at each contact point are defined by the specification;
adjusting a height one or more height adjustable elements of the storage grid corresponding to each contact point, wherein the amount of height adjustment for each height adjustable element is defined by the specification;
installing vertical frame members of different relative lengths according to the specification.

12. The method for installing a storage grid of an automated storage and retrieval system on a floor, the method comprising:
displaying, via a graphical user interface, a view of at least a portion of the floor;
displaying, as an overlay on the view of at least a portion of the floor, a graphical view of an installation specification, the installation specification showing:
the position on the floor of each contact point between the storage grid and the floor; and
information relating to the height compensation required for each contact point.

13. The method of claim 12, wherein the information relating to the height compensation for each contact point includes one or more of:
a numerical value for the height compensation;
a number of shims required to provide the height compensation for each contact point;
an amount of height adjustment required for height adjustable elements of the storage grid corresponding the contact points;
a length of a vertical frame member of the storage grid that is to be placed at that contact point.

14. A system comprising:
one or more processors; and
one or more computer-readable media storing instructions that, when executed by the one or more processors, cause the one or more processors to carry out the method of any preceding claim.

15. One or more computer-readable media storing instructions that, when executed by one or more processors, cause the one or more processors to carry out the method of any of claims 1 to 13.
